# FASCICULE DE BREVET EUROPEEN

(11) **EP 2 656 698 B1**
(45) Date de publication et mention de la délivrance du brevet: **25.03.2015**
(21) Numéro de dépôt: 11815515.9
(22) Date de dépôt: 22.12.2011
(51) Int. Cl.: H05K 1/02, H05K 1/05, H05K 3/40

(54) **CIRCUIT IMPRIME A SUBSTRAT METALLIQUE ISOLE**
LEITERPLATTE MIT EINEM ISOLIERTEN METALLSUBSTRAT
PRINTED CIRCUIT BOARD WITH AN INSULATED METAL SUBSTRATE

(30) Priorité: 23.12.2010 FR 1061107
(43) Date de publication de la demande: 30.10.2013
(73) Titulaire: Valeo Systèmes de Contrôle Moteur, 95800 Cergy (FR)
(72) Inventeur: TALON, Emmanuel, F-78480 Verneuil Sur Seine (FR); DUPUIS, Dominique, CM111DH Billericay (GB); MACHET, François, F-78300 Poissy (FR)
(86) Numéro de dépôt international: PCT/FR2011/053144
(87) Numéro de publication internationale: WO 2012/085472

(56) Documents cités:
- EP-A1- 0 525 644
- US-A1- 2005 263 482
- US-A1- 2007 290 307
- US-A1- 2009 085 050

## Description

La présente invention a pour objet un circuit imprimé à substrat métallique isolé.

Un circuit imprimé est un support, en général une plaque, permettant de relier électriquement un ensemble de composants électroniques entre eux, dans le but de réaliser un circuit électronique complexe. On le désigne aussi par le terme de carte électronique.

La suite de la description est consacrée aux circuits imprimés à substrat métallique isolé.

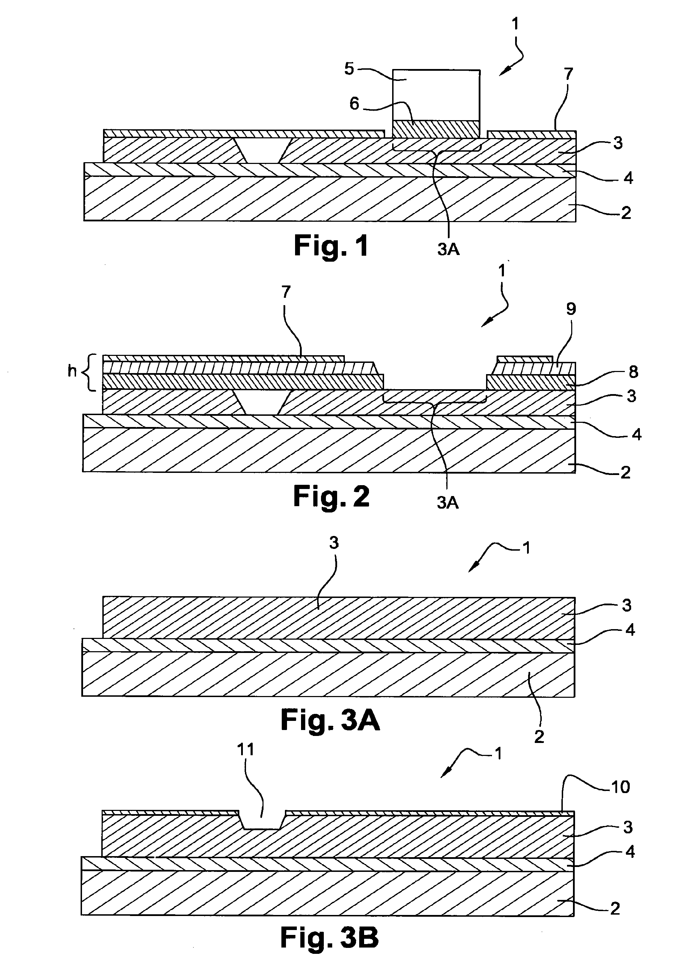

Un circuit imprimé 1 à substrat métallique isolé, tel qu'illustré à la figure 1, comprend un support métallique 2, typiquement une plaque de cuivre ou d'aluminium, des pistes de cuivre 3 formées dans une couche d'un feuillard de cuivre et sur lesquelles sont implantés des composants électroniques 5 via une couche de brasure 6, ainsi qu'un matériau isolant 4 séparant le support métallique 2 des pistes de cuivre 3. Le matériau isolant 4 est typiquement une résine époxy. Des composants électroniques 5 sont implantés sur les pistes de cuivre 3 au niveau de zones d'implantation 3A des pistes de cuivre 3.

Les pistes de cuivre 3 sont classiquement obtenues par sérigraphie. Les zones correspondant aux pistes souhaitées sont masquées, puis un bain chimique ou électrolytique est appliqué.

Vient ensuite une étape de finition qui peut comprendre la finition des zones d'implantation 3A pour le brasage, ainsi que la pose d'une couche de vernis 7 qui protège les pistes 3 de l'oxydation et d'éventuels courts-circuits.

La structure obtenue est un circuit imprimé à substrat métallique isolé à une couche de pistes de cuivre.

Il est également possible de fabriquer un circuit imprimé 1 à substrat métallique isolé à deux couches de pistes de cuivre, tel qu'illustré à la figure 2, sur laquelle les éléments identiques à ceux de la figure 1 portent les mêmes références.

Après le premier bain qui a dessiné les pistes 3 souhaitées, on procède à un dépôt sélectif d'une couche de matériau diélectrique 8 sur les zones différentes des zones d'implantation 3A. On dépose ensuite sur la couche de matériau diélectrique 8 une deuxième couche de cuivre 9 puis éventuellement une couche de vernis 7.

Il existe ainsi au niveau de la zone d'implantation 3A une différence de hauteur h, appelée surépaisseur, entre la surface des premières pistes de cuivre 3 et la surface de la couche de vernis 7. Cette surépaisseur h définit une cavité dans laquelle on dispose un matériau de brasage destiné à assurer une liaison mécanique et électrique entre les pistes de cuivre 3 et les composants électroniques.

Un problème peut survenir lorsque la couche de brasure est trop épaisse. En effet, une couche de brasure trop épaisse, par exemple d'épaisseur supérieure à 150 µm, pose des problèmes du point de vue de la qualité de la brasure et rend la soudure plus difficile.

Les documents US 2005/263482, US 2009/085050, US 2007//290307 et EP 0 525 644 divulguent l'état de la technique antérieure.

La présente invention vise à remédier à ces inconvénients.

Elle propose en particulier un circuit imprimé à substrat métallique isolé permettant un brasage efficace des composants électroniques sur les pistes de cuivre.

L'invention a ainsi pour objet un circuit imprimé à substrat métallique isolé tel que défini dans la revendication 1.

Conformément à l'invention, chaque zone d'implantation est une zone surélevée de la couche de matériau métallique.

Ainsi, comme la zone d'implantation est surélevée, on peut employer une couche de brasure moins épaisse, ce qui rend la soudure plus fiable, en particulier lorsque la zone d'implantation est entourée de couches en surépaisseur de la première couche de pistes métalliques, comme par exemple dans un circuit imprimé à plus de deux couches de pistes métalliques.

Le circuit imprimé peut comprendre une couche de brasure entre chaque zone d'implantation et le composant électronique implanté sur ladite zone d'implantation.

L'invention s'applique à une zone d'implantation issue d'un niveau inférieur de pistes métalliques et entourée d'un niveau supérieur de pistes métalliques.

En particulier, la zone d'implantation est une zone d'une couche inférieure de matériau métallique, la zone d'implantation étant entourée d'une couche de matériau diélectrique disposée sur la couche inférieure de matériau métallique et d'une couche supérieure de matériau métallique disposée sur la couche de matériau diélectrique.

Le circuit imprimé peut comprendre :
- une première couche de matériau métallique munie d'au moins une zone d'implantation surélevée,
- une couche de matériau diélectrique disposée sur la première couche de matériau métallique sur des zones distinctes de la zone d'implantation, de part et d'autre de la zone d'implantation, et
- une deuxième couche de matériau métallique disposée sur la couche de matériau diélectrique, de part et d'autre de la zone d'implantation surélevée.

La surface supérieure de chaque zone d'implantation peut être située à une hauteur comprise entre la hauteur de la surface supérieure de la couche de matériau diélectrique et la hauteur de la surface supérieure de la deuxième couche de matériau métallique.

Chaque couche de matériau métallique peut comprendre une ou plusieurs pistes.

Chaque couche de matériau métallique peut être une couche de cuivre.

D'autres caractéristiques et avantages de la présente invention apparaîtront plus clairement à la lecture de la description suivante donnée à titre d'exemple illustratif et non limitatif et faite en référence aux dessins annexés sur lesquels :
- la figure 1, déjà décrite, illustre un circuit imprimé à substrat métallique isolé à une couche de pistes métalliques de l'état de la technique,
- la figure 2, déjà décrite, illustre un circuit imprimé à substrat métallique isolé à deux couches de pistes métalliques de l'état de la technique, et
- les figures 3A à 3F illustrent différentes étapes d'un procédé de fabrication d'un circuit imprimé selon l'invention.

La figure 3A illustre un circuit imprimé 1 avant l'étape de sérigraphie, le circuit imprimé 1 étant muni d'un support en cuivre 2 recouvert d'une couche d'isolant 4 destinée à isoler le support 2 d'une première couche de cuivre 3 sensiblement plane servant de base pour la formation de pistes de cuivre.

Une couche de masquage 10 est ensuite disposée sur la plaque de cuivre 3. Les zones correspondant aux pistes souhaitées sont ainsi masquées, puis un premier bain est appliqué de manière à commencer la formation d'une tranchée 11 dans la première couche de cuivre 3 (figure 3B).

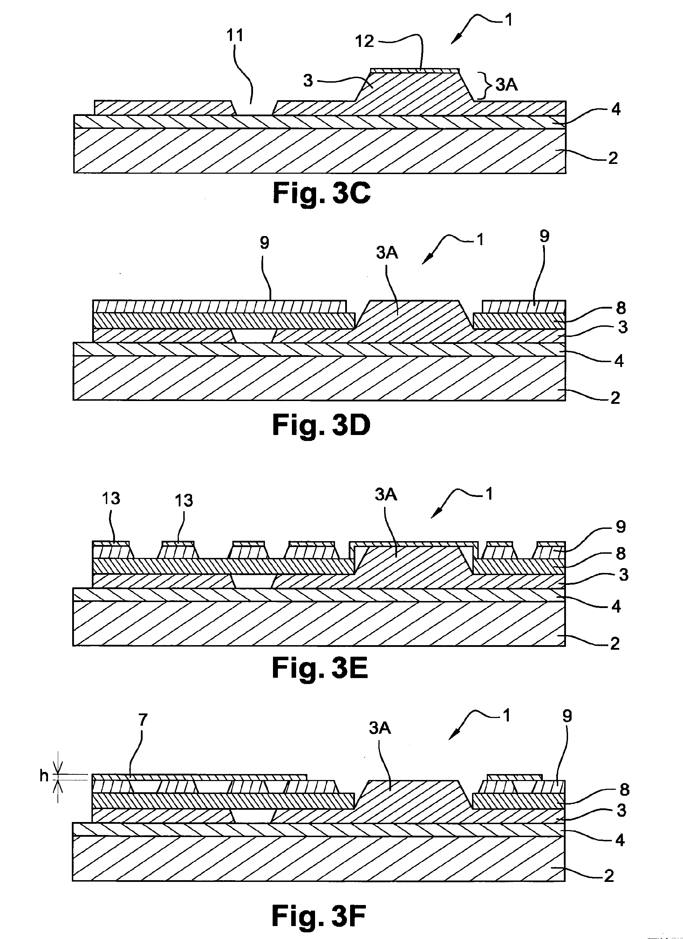

On procède dans une deuxième étape au masquage de la zone d'implantation destinée à l'accueil d'un composant électronique, à l'aide d'une couche de masquage 12, puis on applique un deuxième bain qui permet de terminer la gravure de la tranchée 11 et de former la zone d'implantation surélevée 3A (figure 3C). La zone d'implantation 3A peut présenter une section trapézoïdale.

Tel qu'illustré à la figure 3D, on procède ensuite à un dépôt sélectif d'une couche de matériau diélectrique 8 sur les pistes de cuivre 3, de part et d'autre de la zone d'implantation surélevée 3A, puis on dépose une deuxième couche de cuivre 9, également de part et d'autre de la zone d'implantation 3A.

On procède ensuite à la gravure de la seconde épaisseur de pistes 9 à l'aide de masques 13 (figure 3E), puis une couche de vernis 7 finale est déposée (figure 3F). La surface de la zone d'implantation 3A se trouve ainsi sensiblement au même niveau que la surface de la deuxième couche de pistes de cuivre 9, par exemple légèrement en dessous de la surface des pistes de cuivre 9.

Le procédé se termine par une étape de brasage destinée à souder un composant électronique sur la zone d'implantation 3A. Une épaisseur classique de la couche de brasure est de l'ordre de 150 µm. Le dépôt de la couche de brasure peut être obtenue par sérigraphie au moyen d'un pochoir. Grâce à la zone d'implantation 3A en saillie de la couche de cuivre 3, la surépaisseur finale h est réduite, ce qui permet d'obtenir une couche de brasure présentant une épaisseur de 150 µm, malgré la surépaisseur liée à la couche de matériau isolant 8 et à la deuxième couche de cuivre 9. Ainsi, le brasage du composant électronique sur la piste de cuivre 3 est amélioré.

La couche de matériau métallique (ou première couche métallique) 3 qui comprend la zone d'implantation 3A est une couche pour la formation de pistes métalliques. Ceci est particulièrement observable en figures 3C à 3F dans lesquelles une tranchée 11 sépare la piste comprenant la zone d'implantation 3A d'une autre piste. Par exemple, la première couche métallique 3 comprend des pistes métalliques permettant la transmission de courants électriques, telles que des routages électroniques.

Le support métallique 2 est une masse thermique permettant la dissipation thermique de la chaleur produite par le circuit 1.

## Revendications

1. Circuit imprimé (1) à substrat métallique isolé, comprenant un support métallique (2), une couche d'isolant (4) et une couche de matériau métallique (3) sur laquelle est implanté au moins un composant électronique (5) au niveau d'au moins une zone d'implantation (3A) de la couche de matériau métallique (3), chaque zone d'implantation (3A) étant une zone surélevée de la couche de matériau métallique (3) et **caractérisé en ce que** chaque zone d'implantation (3A) est une zone d'une couche inférieure de matériau métallique (3), chaque zone d'implantation (3A) étant entourée d'une couche de matériau diélectrique (8) disposée sur la couche inférieure de matériau métallique (3) et d'une couche supérieure de matériau métallique (9) disposée sur la couche de matériau diélectrique (8).

2. Circuit imprimé (1) selon la revendication 1, **caractérisé en ce qu'**il comprend une couche de brasure (6) entre chaque zone d'implantation (3A) et le composant électronique (5) implanté sur ladite zone d'implantation (3A).

3. Circuit imprimé (1) selon la revendication 1 ou 2, **caractérisé en ce qu'**il comprend :
- une première couche de matériau métallique (3) munie d'au moins une zone d'implantation surélevée (3A),
- une couche de matériau diélectrique (8) disposée sur la première couche de matériau métallique (3) sur des zones distinctes de la zone d'implantation (3A), de part et d'autre de la zone d'implantation (3A), et
- une deuxième couche de matériau métallique (9) disposée sur la couche de matériau diélectrique (8), de part et d'autre de la zone d'implantation (3A).

4. Circuit imprimé (1) selon l'une des revendications 1 à 3, **caractérisé en ce que** la surface supérieure de chaque zone d'implantation (3A) est située à une hauteur comprise entre la hauteur de la surface supérieure de la couche de matériau diélectrique (8) et la hauteur de la surface supérieure de la deuxième couche de matériau métallique (9).

5. Circuit imprimé (1) selon l'une des revendications 1 à 4, **caractérisé en ce que** chaque couche de matériau métallique (3,9) comprend une ou plusieurs pistes.

6. Circuit imprimé (1) selon l'une des revendications 1 à 5, **caractérisé en ce que** chaque couche de matériau métallique (3,9) est une couche de cuivre.

## Patentansprüche

1. Gedruckte Schaltung (1) auf einem isolierten Metallsubstrat, die einen Metallträger (2), eine Isolierschicht (4) und eine Schicht (3) aus Metallmaterial umfasst, auf der wenigstens eine elektronische Komponente (5) auf Höhe wenigstens einer Implantationszone (3A) der Schicht (3) aus Metallmaterial implantiert ist, wobei jede Implantationszone (3A) eine erhöhte Zone der Schicht (3) aus Metallmaterial ist, **dadurch gekennzeichnet, dass** jede Implantationszone (3A) eine Zone einer unteren Schicht (3) aus Metallmaterial ist, wobei jede Implantationszone (3A) von einer Schicht (8) aus dielektrischem Material, die auf der unteren Schicht (3) aus Metallmaterial angeordnet ist, und von einer oberen Schicht (9) aus Metallmaterial, die auf der Schicht (8) aus dieelektrischem Material angeordnet ist, umgeben ist.

2. Gedruckte Schaltung (1) nach Anspruch 1, **dadurch gekennzeichnet, dass** sie eine Lötschicht (6) zwischen jeder Implantationszone (3A) und der elektronischen Komponente (5), die auf der Implantationszone (3A) implantiert ist, umfasst.

3. Gedruckte Schaltung (1) nach Anspruch 1 oder 2, **dadurch gekennzeichnet, dass** sie Folgendes umfasst:
- eine erste Schicht (3) aus Metallmaterial, die mit wenigstens einer erhöhten Implantationszone (3A) versehen ist,
- eine Schicht (8) aus dielektrischem Material, die auf der ersten Schicht (3) aus Metallmaterial auf Zonen, die von der Implantationszone (3A) verschieden ist, beiderseits der Implantationszone (3A) angeordnet ist, und
- eine zweite Schicht (9) aus Metallmaterial, die auf der Schicht (8) aus dielektrischem Material beiderseits der Implantationszone (3A) angeordnet ist.

4. Gedruckte Schaltung (1) nach einem der Ansprüche 1 bis 3, **dadurch gekennzeichnet, dass** sich die obere Oberfläche jeder Implantationszone (3A) auf einer Höhe befindet, die zwischen der Höhe der oberen Oberfläche der Schicht (8) aus dielektrischem Material und der Höhe der oberen Oberfläche der zweiten Schicht (9) aus Metallmaterial liegt.

5. Gedruckte Schaltung (1) nach einem der Ansprüche 1 bis 4, **dadurch gekennzeichnet, dass** jede Schicht (3, 9) aus Metallmaterial eine oder mehrere Bahnen umfasst.

6. Gedruckte Schaltung (1) nach einem der Ansprüche 1 bis 5, **dadurch gekennzeichnet, dass** jede Schicht (3, 9) aus Metallmaterial eine Kupferschicht ist.

## Claims

1. Printed circuit board (1) with an insulated metal substrate, comprising a metal carrier (2), an insulating layer (4) and a metal layer (3) on which at least one electronic component (5) is mounted in at least one mounting zone (3A) of the metal layer (3), each mounting zone (3A) being a raised zone of the metal layer (3) and **characterized in that** each mounting zone (3A) is a zone of a lower metal layer (3), each mounting zone (3A) being surrounded by a dielectric layer (8) placed on the lower metal layer (3), and an upper metal layer (9) placed on the dielectric layer (8).

2. Printed circuit board (1) according to Claim 1, **characterized in that** it comprises a solder layer (6) between each mounting zone (3A) and the electronic component (5) mounted on said mounting zone (3A).

3. Printed circuit board (1) according to either of Claims 1 and 2, **characterized in that** it comprises:
- a first metal layer (3) equipped with at least one raised mounting zone (3A);
- a dielectric layer (8) placed on the first metal layer (3) on separate zones of the mounting zone (3A), on either side of the mounting zone (3A); and
- a second metal layer (9) placed on the dielectric layer (8), on either side of the mounting zone (3A).

4. Printed circuit board (1) according to one of Claims 1 to 3, **characterized in that** the upper surface of each mounting zone (3A) is located at a height between the height of the upper surface of the dielectric layer (8) and the height of the upper surface of the second metal layer (9).

5. Printed circuit board (1) according to one of Claims 1 to 4, **characterized in that** each metal layer (3, 9) comprises one or more tracks.

6. Printed circuit board (1) according to one of Claims 1 to 5, **characterized in that** each metal layer (3, 9) is a copper layer.
